(19) Europäisches Patentamt
European Patent Office
Office européen des brevets

(11) EP 2 803 634 B1

(12) **FASCICULE DE BREVET EUROPEEN**

(45) Date de publication et mention
de la délivrance du brevet:
**09.12.2015 Bulletin 2015/50**

(51) Int Cl.:
***B81C 1/00*** *(2006.01)*     ***H01L 21/52*** *(2006.01)*
***H01L 21/54*** *(2006.01)*     ***H01L 23/31*** *(2006.01)*
***H01L 23/10*** *(2006.01)*

(21) Numéro de dépôt: **14168106.4**

(22) Date de dépôt: **13.05.2014**

(54) **Procédé d'encapsulation d'un dispositif microélectronique comprenant une injection de gaz noble à travers un matériau perméable à ce gaz noble**

Einkapselungsverfahren für eine mikroelektronische Vorrichtung mittels der Injektion von einem Edelgas durch ein Material, welches für dieses Edelgas durchlässig ist

Method for encapsulating a microelectronic device with the injection of a noble gas through a material permeable to this noble gas

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.05.2013 FR 1354349**

(43) Date de publication de la demande:
**19.11.2014 Bulletin 2014/47**

(73) Titulaire: **Commissariat à l'Énergie Atomique et aux Énergies Alternatives
75015 Paris (FR)**

(72) Inventeur: **Nicolas, Stéphane
38240 Meylan (FR)**

(74) Mandataire: **Ilgart, Jean-Christophe et al
BREVALEX
95, rue d'Amsterdam
75378 Paris Cedex 8 (FR)**

(56) Documents cités:
**EP-A2- 2 362 182       FR-A1- 2 841 380
US-A1- 2007 259 470**

**Description**

**DOMAINE TECHNIQUE ET ART ANTÉRIEUR**

L'invention concerne le domaine de la microélectronique et plus particulièrement celui du packaging, ou encapsulation, d'un dispositif microélectronique tel qu'un microsystème de type MEMS (« Micro-Electro-Mechanical Systems »), NEMS (« Nano-Electro-Mechanical Systems »), MOEMS (« Micro-Opto-Electro-Mechanical Systems »), ou encore NOEMS (« Nano-Opto-Electro-Mechanical Systems »), consistant à encapsuler, ou enfermer, ce dispositif dans une cavité hermétique dont l'atmosphère est contrôlée. Le procédé d'encapsulation selon l'invention est avantageusement mis en oeuvre pour réaliser une encapsulation collective de plusieurs dispositifs microélectroniques dans des cavités distinctes dans lesquelles un gaz noble est enfermé à des pressions différentes.

L'encapsulation d'un dispositif microélectronique permet d'une part de le protéger vis-à-vis des éléments extérieurs (humidité, pollution particulaire, éléments réactifs tels que l'oxygène ou d'autres gaz non neutres), et d'autre part de contrôler l'atmosphère (pression, composition du gaz encapsulé, etc.) régnant dans la cavité dans laquelle ce dispositif est encapsulé. La pression d'encapsulation régnant dans la cavité est variable suivant l'application envisagée et est typiquement comprise entre environ 1 bar à $10^{-3}$ mbar.

Une contrainte récurrente dans le domaine du packaging de ce type de dispositif est donc de réaliser un contrôle très précis de la pression dans la cavité dans laquelle le dispositif est encapsulé. Par exemple, pour un dispositif MEMS de type gyroscope, une encapsulation de celui-ci dans un environnement sous vide poussé (par exemple à une pression comprise entre environ $10^{-1}$ et $10^{-3}$ mbar) est généralement nécessaire pour obtenir un bon fonctionnement de ce type de dispositif. Pour un dispositif MEMS de type commutateur RF (Radio Fréquence), une encapsulation à une pression proche de la pression atmosphérique mais dans un environnement gazeux « neutre » est recherchée pour éviter par exemple une oxydation des zones de contact du commutateur. Il est dans ce cas nécessaire d'encapsuler le commutateur dans un environnement gazeux de type $N_2$, Ar, ou He.

Le packaging de ce type de dispositif est généralement réalisé à l'échelle du substrat afin de réaliser collectivement l'encapsulation de plusieurs dispositifs microélectroniques réalisés sur un même substrat, afin de réduire les coûts de fabrication de ces dispositifs. Un tel packaging peut notamment être réalisé par le scellement hermétique d'un substrat capot sur un premier substrat comprenant les dispositifs. Il existe différentes techniques de scellement permettant d'obtenir un assemblage hermétique du substrat capot avec le premier substrat, comme par exemple le scellement moléculaire (ou collage direct), le scellement métallique, le scellement anodique, ou encore le scellement par verre fritté. Dans le cas d'un scellement moléculaire ou anodique, les deux substrats sont collés directement l'un contre l'autre, tandis que dans le cas d'un scellement métallique ou par verre fritté, un joint de scellement est présent entre les deux substrats et assure la cohésion de la structure d'encapsulation.

Les principaux paramètres à prendre en compte pour le contrôle de la pression dans une cavité d'encapsulation sont :

- l'herméticité du joint de scellement éventuellement présent entre les substrats ;
- la perméation des gaz à travers les parois de la cavité formées par les substrats et/ou le joint de scellement ;
- les dégazages des différents matériaux présents dans la cavité.

Dans le cas où un vide est recherché dans la cavité (par exemple à une pression inférieure à environ 1 mbar), il est généralement nécessaire de déposer un matériau getter à l'intérieur de la cavité. Ce matériau getter peut être formé d'une ou de plusieurs couches minces métalliques (typiquement du zirconium ou du titane) déposées par exemple par dépôt physique en phase vapeur (PVD).

Il existe des composants particuliers comprenant chacun un accéléromètre tri-axes, un gyroscope tri-axes ainsi qu'un magnétomètre tri-axes, formant ainsi un capteur inertiel à 9 axes de détection. Pour ce type de composant, les dispositifs microélectroniques triaxiaux (accéléromètre, gyroscope et magnétomètre) sont généralement fabriqués indépendamment les uns des autres puis assemblés lors du packaging final du composant, ce qui correspond dans ce cas à un procédé d'encapsulation non collectif.

Pour des raisons de réduction des coûts de fabrication de ce type de composant, il est envisagé d'intégrer les différents dispositifs microélectroniques du composant sur un même substrat. Toutefois, ce type d'intégration pose des problèmes.

En effet, un accéléromètre fonctionne généralement avec une pression résiduelle (pression régnant dans la cavité d'encapsulation) assez élevée (supérieure à environ 1 mbar) afin d'être suffisamment amorti, alors qu'un gyroscope a généralement besoin d'une pression résiduelle la plus faible possible (par exemple entre environ $10^{-1}$ et $10^{-4}$ mbar) pour fonctionner de manière optimale. Or, il est très difficile de pouvoir packager, et donc de sceller hermétiquement, des cavités avec des pressions résiduelles très différentes et cela sur un même substrat.

Une première solution peut consister à réaliser un scellement des cavités de l'accéléromètre et du gyroscope sous une pression très faible (par exemple entre environ $10^{-3}$ et $10^{-5}$ mbar), et disposer un matériau getter dans la cavité du gyroscope et de ne pas en mettre dans la cavité de l'accéléromètre. Le matériau getter va permettre de maintenir une pression résiduelle très faible dans la cavité du gyroscope (inférieure à environ $10^{-1}$ mbar) en adsorbant les gaz libérés par les différents matériaux présents dans la cavité lors du scellement.

Cette première solution fonctionne mais ne permet pas d'atteindre des différences de pression importantes entre les deux cavités: typiquement, la pression résiduelle dans la cavité de l'accéléromètre sera comprise entre quelques mbar et quelques dizaines de mbar en raison des dégazages des différents matériaux contenus dans la cavité de l'accéléromètre lors du scellement. Or, dans certains cas, pour l'accéléromètre, il est nécessaire d'avoir une pression résiduelle supérieure à environ 100 mbar voir proche d'environ 1 bar (fort amortissement). Dans ce cas, la solution décrite auparavant ne peut pas fonctionner.

Une deuxième solution peut consister à réaliser le scellement des deux cavités sous pression atmosphérique (par exemple à une pression d'environ 1 bar), et de disposer un matériau getter dans la cavité du gyroscope.

Toutefois, en raison de la capacité de pompage limitée et à l'encombrement limité du matériau getter (dont la taille maximale est limitée par les dimensions de la cavité), il ne sera dans ce cas pas possible de descendre à une pression résiduelle inférieure à environ 1 mbar dans la cavité du gyroscope car le getter sera saturé avant d'atteindre une telle pression.

Quelque soit la solution choisie (scellement à faible pression ou à pression atmosphérique), un des deux dispositifs n'est pas encapsulé avec une pression résiduelle correspondant à sa gamme de pression résiduelle nécessaire à son fonctionnement optimal.

Le document US 8 350 346 B1 décrit un composant comportant des cavités de volumes différents dans lesquelles sont encapsulés un gyroscope et un accéléromètre. Le volume de la cavité dans laquelle est encapsulé l'accéléromètre est inférieur à celui de la cavité dans laquelle le gyroscope est encapsulé. Ainsi, la pression après packaging dans la cavité de l'accéléromètre est plus élevée que celle dans la cavité du gyroscope. Toutefois, une telle structure ne permet pas d'obtenir des différences de pressions allant de 1 bar à $10^{-3}$ mbar dans les différentes cavités.

Le document FR 2 841 380 A1 décrit un procédé d'encapsulation d'un dispositif microélectronique sous atmosphère contrôlée. Dans ce procédé, le dispositif microélectronique est placé dans une cavité pourvue d'un évent prévu pour mettre l'intérieur de la cavité en contact avec l'extérieur de celle-ci. L'évent est ensuite obturé au moyen d'une couche intermédiaire en matériau poreux qui permet de ralentir les échanges gazeux entre la cavité et le milieu extérieur. Puis, la cavité est mise sous atmosphère contrôlée. Une couche d'encapsulation étanche est finalement déposée sur la couche en matériau poreux de façon à fermer l'évent de façon étanche.

## EXPOSÉ DE L'INVENTION

Un but de la présente invention est de proposer un procédé d'encapsulation d'un dispositif microélectronique permettant de contrôler précisément l'atmosphère, en termes de pression et de composition gazeuse, dans laquelle est encapsulé le dispositif microélectronique, et qui permet également, lorsqu'il est mis en oeuvre pour réaliser une encapsulation collective de plusieurs dispositifs microélectroniques, d'encapsuler les dispositifs dans des cavités différentes dans lesquelles règnent des pressions résiduelles différentes d'au moins un gaz noble.

Pour cela, la présente propose un procédé d'encapsulation d'au moins un dispositif microélectronique, comportant au moins les étapes de :

- réalisation du dispositif microélectronique sur un premier substrat ;
- réalisation d'au moins une portion d'un premier matériau non perméable à l'atmosphère ambiante et perméable à au moins un gaz noble dans un deuxième substrat non perméable à l'atmosphère ambiante et au gaz noble, ladite portion du premier matériau s'étendant depuis une première face du deuxième substrat jusqu'à une autre face du deuxième substrat opposée à la première face ;
- solidarisation du deuxième substrat au premier substrat, formant au moins une cavité dans laquelle est encapsulé le dispositif microélectronique telle que ladite portion du premier matériau forme au moins une partie d'une paroi de la cavité ;
- injection du gaz noble dans la cavité à travers la portion du premier matériau ;
- fermeture hermétique de la cavité vis-à-vis de l'atmosphère ambiante et du gaz noble.

Le terme « gaz noble » désigne par la suite un ou plusieurs gaz nobles, ou gaz rares ou chimiquement inertes, correspondant aux éléments chimiques du groupe 18 du tableau périodique des éléments, c'est-à-dire de l'hélium et/ou du néon et/ou de l'argon et/ou du krypton et/ou du xénon et/ou du radon. De plus, le terme « dispositif microélectronique » désigne tout type de dispositif du domaine de l'électronique, de dimensions micrométriques ou nanométriques, et par exemple de type MEMS, NEMS, MOEMS ou encore NOEMS.

L'atmosphère ambiante peut être de l'air ou une atmosphère contrôlée (avec par exemple un mélange de gaz) environnant la structure encapsulant le dispositif microélectronique. Le ou les gaz de l'atmosphère ambiante sont différents dudit gaz noble.

Ce procédé utilise la propriété du premier matériau d'être perméable uniquement à un ou plusieurs gaz nobles, et non perméable, ou non poreux à l'atmosphère ambiante.

Du fait que le gaz noble est injecté dans la cavité après la solidarisation du deuxième substrat, formant un substrat capot, au premier substrat, la quantité du gaz noble injecté à travers la portion du premier matériau peut être contrôlée précisément notamment via le choix des dimensions de cette portion du premier matériau dans le plan du deuxième substrat. Ce procédé permet notamment d'obtenir dans la cavité une pression résiduelle du gaz noble allant d'environ 10⁻⁴ mbar à environ 1 bar, ou même une pression supérieure à 1 bar.

Le procédé selon l'invention a également pour avantage de pouvoir être mis en oeuvre avec des techniques de fabrication standards du domaine de la microélectronique (fabrication MEMS, scellement, etc.).

Le deuxième substrat peut correspondre à une unique couche de matériau ou comporter plusieurs couches de matériau.

La réalisation de la portion du premier matériau peut comporter la mise en oeuvre des étapes suivantes :

- réalisation, à travers la première face du deuxième substrat, d'au moins une ouverture, ou trou, dans une partie de l'épaisseur du deuxième substrat ;
- formation de la portion du premier matériau dans l'ouverture ;
- suppression d'une partie du deuxième substrat depuis une deuxième face du deuxième substrat opposée à la première face, découvrant, ou révélant, la portion du premier matériau et formant ladite autre face du deuxième substrat.

Le premier matériau peut comporter du verre ou de l'oxyde de semi-conducteur.

Le premier matériau peut comporter du verre et la formation de la portion du premier matériau dans l'ouverture peut comporter la mise en oeuvre des étapes suivantes :

- solidarisation d'un troisième substrat de verre contre la première face du deuxième substrat et en regard de l'ouverture ;
- refusion du verre d'au moins une partie du troisième substrat dans l'ouverture, formant la portion du premier matériau dans l'ouverture.

Après l'étape de refusion du verre, le procédé peut comporter une étape de suppression du verre du troisième substrat se trouvant en dehors de l'ouverture.

Le deuxième substrat peut comporter du semi-conducteur, et l'étape de réalisation de l'ouverture peut comporter la mise en oeuvre d'une gravure dans ladite partie de l'épaisseur du deuxième substrat telle que des portions restantes du semi-conducteur du deuxième substrat soient conservées dans l'ouverture, la formation de la portion du premier matériau dans l'ouverture pouvant comporter la mise en oeuvre d'une oxydation desdites portions restantes de semi-conducteur.

Le deuxième substrat peut comporter du semi-conducteur, et la réalisation de la portion du premier matériau peut comporter la mise en oeuvre des étapes suivantes :

- réalisation, à travers la première face du deuxième substrat, de porosités, ou pores, dans une partie de l'épaisseur du deuxième substrat ;
- oxydation de la partie poreuse du deuxième substrat, formant la portion du premier matériau ;
- suppression d'une partie du deuxième substrat depuis une deuxième face du deuxième substrat opposée à la première face, découvrant la portion du premier matériau et formant ladite autre face du deuxième substrat.

Le procédé peut comporter en outre, après l'étape d'oxydation et lorsque l'oxydation mise en oeuvre forme de l'oxyde de semi-conducteur en dehors de l'ouverture, une étape de suppression de l'oxyde de semi-conducteur se trouvant en dehors de l'ouverture.

La fermeture hermétique de la cavité vis-à-vis de l'atmosphère ambiante et du gaz noble peut comporter la mise en oeuvre d'un dépôt d'au moins un deuxième matériau non perméable au gaz noble au moins contre ladite portion du premier matériau, au niveau de la première face du deuxième substrat.

Les étapes mises en oeuvre peuvent réaliser une encapsulation d'au moins deux dispositifs microélectroniques dans au moins deux cavités distinctes formées entre le premier substrat et le deuxième substrat, et telles qu'au moins une portion du premier matériau forme au moins une partie d'une paroi d'une des deux cavités. Ainsi, il est possible d'intégrer et d'encapsuler collectivement différents types de dispositifs microélectroniques pouvant fonctionner à des pressions résiduelles différentes, comme par exemple un accéléromètre et un gyroscope.

Les étapes mises en oeuvre peuvent réaliser au moins deux portions du premier matériau formant chacune au moins une partie d'une paroi d'une des deux cavités.

Lesdites au moins deux portions du premier matériau peuvent comporter des dimensions, au niveau de la première face du deuxième substrat et/ou de l'autre face du deuxième substrat, différentes l'une par rapport à l'autre. Ainsi, ces dimensions des portions du premier matériau peuvent être choisies en fonction de la quantité de gaz noble destiné à être injecté dans chacune des cavités.

Au moins un des dispositifs microélectroniques peut être encapsulé dans une des cavités telle qu'aucune paroi de ladite une des cavités n'est perméable au gaz noble. Les étapes mises en oeuvre peuvent réaliser une encapsulation d'au moins un troisième dispositif microélectronique dans une troisième cavité formée entre le premier substrat et le deuxième substrat, et telles qu'aucune paroi de ladite troisième cavité n'est perméable au gaz noble.

Le procédé peut comporter en outre, préalablement à l'étape de solidarisation du deuxième substrat au premier substrat, la réalisation d'au moins une portion de matériau getter dans une ou plusieurs des cavités. Le matériau getter permet d'adsorber les gaz résiduels réactifs tels que l'oxygène ou l'hydrogène par exemple. Seul le ou les gaz nobles non réactifs sont alors présents dans la ou les cavités comportant du matériau getter. Suivant les applications visées, cette ou ces cavités peuvent comporter ou non des portions du premier matériau, les matériau getter étant alors disposés en dehors desdites portions du premier matériau.

Le dispositif microélectronique encapsulé dans la cavité dont aucune paroi n'est perméable au gaz noble peut être un gyroscope, et au moins l'autre des dispositifs microélectroniques peut être un accéléromètre.

Le gaz noble peut comporter de l'hélium et/ou de l'argon et/ou du néon, et/ou l'étape d'injection du gaz noble dans la cavité à travers la portion du premier matériau peut être réalisée en exposant au moins la première face du deuxième substrat au gaz noble à une pression comprise entre environ 1 bar et 6 bars.

Le procédé est avantageusement mis en oeuvre pour un gaz noble comportant du néon et/ou de l'hélium et/ou de l'argon, notamment en raison des faibles dimensions des molécules de ces gaz, facilitant le passage de ce ou ces gaz à travers les portions du premier matériau.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- les figures 1 à 4 représentent les étapes d'un procédé d'encapsulation, objet de la présente invention, selon un mode de réalisation particulier;
- les figures 5A - 5D et 6A - 6B représentent les étapes de réalisation d'un substrat capot selon différentes variantes de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

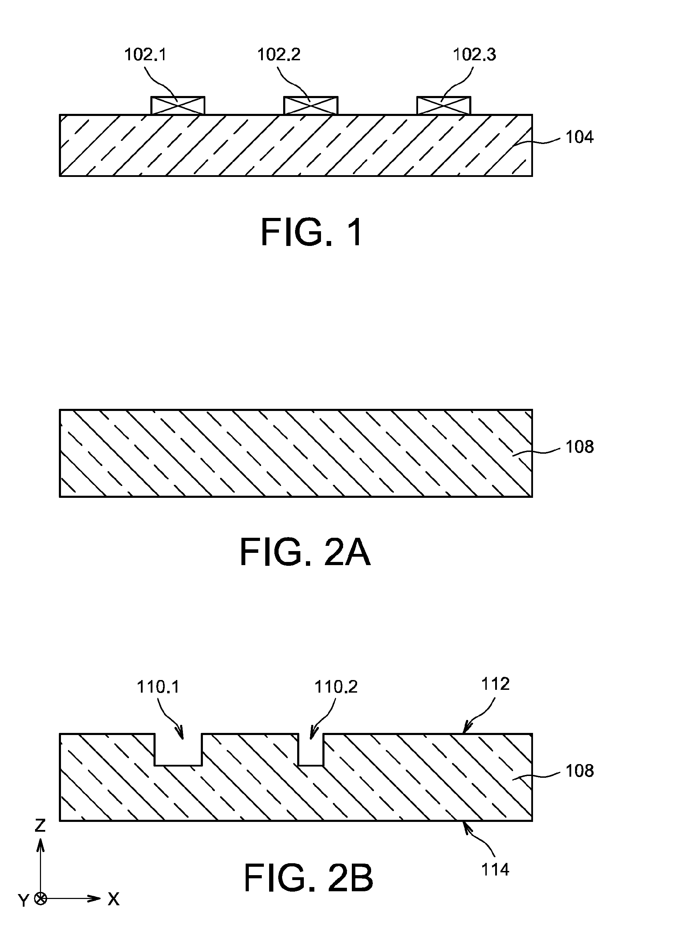

On se réfère tout d'abord aux figures 1 à 4 qui représentent les étapes d'un procédé d'encapsulation d'un dispositif microélectronique dans une atmosphère gazeuse comprenant au moins un gaz noble. Dans le mode de réalisation particulier décrit en liaison avec ces figures, le procédé mis en oeuvre correspond à la réalisation d'un composant, ou puce, 100 de type centrale inertielle, au cours duquel une encapsulation collective de plusieurs dispositifs microélectroniques réalisés sur un même premier substrat et destinés à être encapsulés dans des cavités différentes, et dans des atmosphères différentes, est réalisée.

Comme représenté sur la figure 1, trois dispositifs microélectroniques 102.1 à 102.3 sont réalisés sur un premier substrat 104, ou wafer (dont l'épaisseur est supérieure à environ 100 $\mu$m) comprenant par exemple un substrat semi-conducteur monolithique tel que du silicium. Dans ce mode de réalisation particulier, le premier dispositif 102.1 est par exemple un accéléromètre destiné à être fortement amorti, et donc destiné à être encapsulé avec une pression résiduelle élevée. Le deuxième dispositif 102.2 est par exemple un autre accéléromètre destiné à être faiblement amorti, et donc destiné à être encapsulé avec une pression résiduelle plus faible que celle avec laquelle est encapsulé le premier dispositif 102.1. Le troisième dispositif 102.3 est par exemple un gyroscope. Le matériau du premier substrat 104 est ici non perméable à l'atmosphère ambiante, par exemple non perméable à l'air, et non perméable au gaz noble avec lequel un ou plusieurs des dispositifs 102.1 à 102.3 sont destinés à être encapsulés.

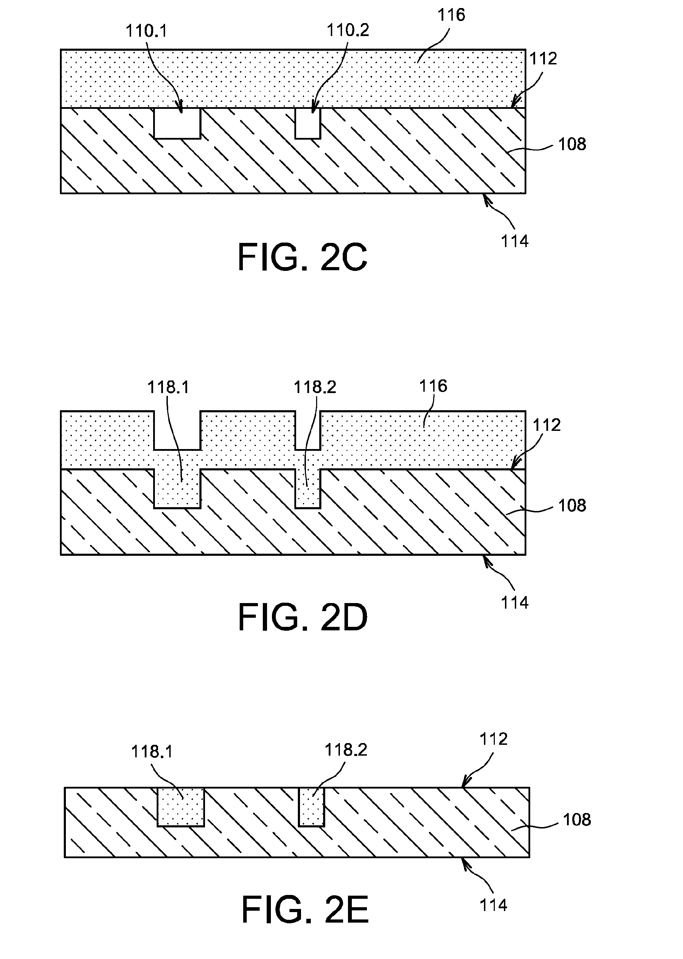

On décrit maintenant, en liaison avec les figures 2A à 2F, la réalisation d'un substrat capot 106 destiné à être solidarisé au premier substrat 104 et réaliser ainsi l'encapsulation des dispositifs microélectroniques 102.1 à 102.3.

Pour cela, un deuxième substrat 108, ou wafer, est utilisé (figure 2A). Ce deuxième substrat 108 comporte un matériau non perméable à l'atmosphère ambiante et non perméable au gaz noble. Le deuxième substrat 108 comporte par exemple un semi-conducteur tel que du silicium.

Des ouvertures 110 sont ensuite réalisées, par exemple par gravure, à travers une partie de l'épaisseur du deuxième substrat 108, par exemple avec une profondeur comprise entre environ 10 $\mu$m et 500 $\mu$m. Ces ouvertures forment des emplacements dans lesquels des portions de matériau non perméable à l'atmosphère ambiante mais perméable au gaz noble, appelées portions d'un premier matériau, sont destinées à être réalisées. Dans le mode de réalisation décrit ici, du fait que seuls les dispositifs 102.1 et 102.2 sont destinés à être encapsulés dans des atmosphères comportant ce gaz noble, seules deux ouvertures 110.1 et 110.2 sont réalisées dans le deuxième substrat 108. De plus, ces ouvertures 110.1 et 110.2 sont réalisées telles que les portions du premier matériau destinées à être réalisées dans ces ouvertures forment, lors de la solidarisation du substrat capot 106 au premier substrat 104, au moins une partie d'une paroi (paroi supérieure dans le cas présent) de chacune des cavités dans lesquelles les deux dispositifs 102.1 et 102.2 sont destinés à être encapsulés.

Les ouvertures 110 sont réalisées à travers une première face 112 du deuxième substrat 108. Le deuxième substrat 108 comporte une deuxième face 114 opposée à la première face 112 et destinée à être disposée en regard du premier substrat 104 lors de la solidarisation des deux substrats 104 et 108. Les dimensions de chacune des ouvertures 110 dans un plan (X,Y) parallèle à la première face 112 correspondent sensiblement aux dimensions souhaitées des portions du premier matériau destinées à être réalisées dans ces ouvertures, ces dimensions étant elles-mêmes choisies en fonction de la quantité de gaz noble qui sera injecté ultérieurement dans les cavités à travers ces portions du premier matériau. Ces dimensions (dans le plan (X,Y)) sont par exemple comprises entre quelques microns et quelques millimètres, par exemple entre environ 2 $\mu$m et 10 mm.

On réalise ensuite les portions du premier matériau dans les ouvertures 110. Pour cela, un troisième substrat 116 de verre est solidarisé contre la première face 112 du deuxième substrat 108. Cette solidarisation est par exemple réalisée via la mise en oeuvre d'un scellement anodique entre le troisième substrat 116 et le deuxième substrat 108. Le verre du troisième substrat 116 est par exemple un verre de type silice fondue ou un de ses dérivés, par exemple un verre borosilicate, par exemple de type Pyrex ® ou borosilicate flotté (Borofloat ®), qui est non poreux vis-à-vis de l'atmosphère ambiante.

Comme représenté sur la figure 2D, un recuit est mis en oeuvre, par exemple à une température comprise entre environ 550°C et 860°C, entraînant une refusion partielle du verre du troisième substrat 116 et formant ainsi, dans les ouvertures 110, des portions 118 du premier matériau qui est ici du verre et qui correspond bien à un matériau non perméable à l'atmosphère ambiante et perméable au gaz noble (portions 118.1 et 118.2 respectivement formées dans les ouvertures 110.1 et 110.2 sur l'exemple décrit ici).

Le verre du troisième substrat 116 se trouvant en dehors des ouvertures 110 est ensuite supprimé, par exemple par la mise en oeuvre d'un meulage puis d'une planarisation mécano-chimique avec arrêt sur la première face 112 du deuxième substrat 108 (figure 2E).

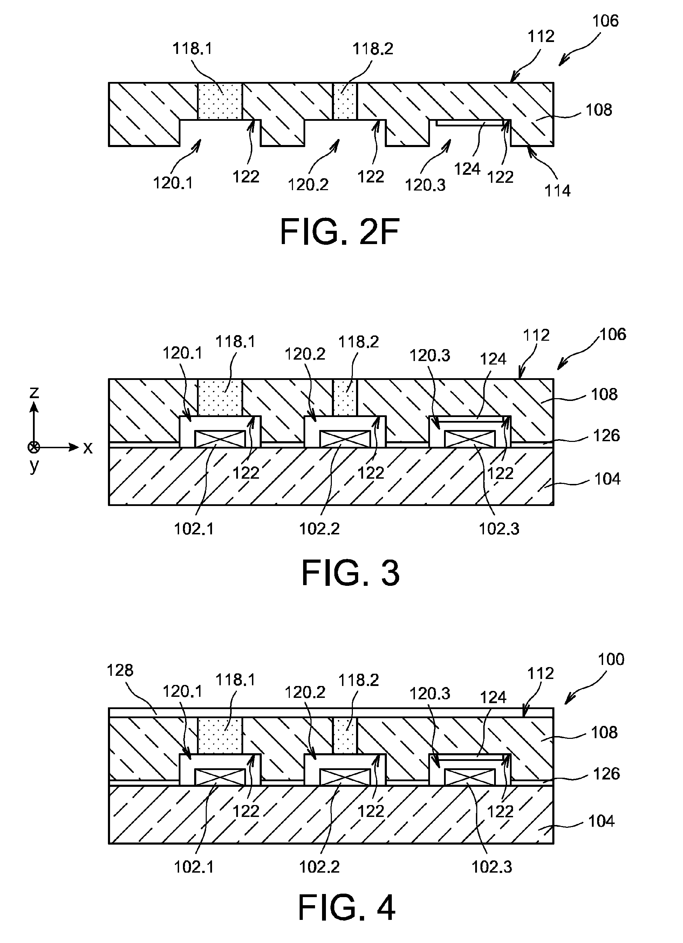

Le substrat capot 106 est achevé en gravant, à travers la deuxième face 114 du deuxième substrat 108 et sur une partie de l'épaisseur du deuxième substrat 108, des cavités 120 dans lesquelles les dispositifs microélectroniques 102.1 à 102.3 sont destinés à être encapsulés (figure 2F).

Cette gravure est mise en oeuvre jusqu'à une autre face 122 du deuxième substrat 108 (cette autre face 122 se trouvant entre les deux faces principales 112 et 114 du deuxième substrat 108) au niveau de laquelle les portions 118 sont découvertes, ou accessibles. Les portions 118 sont donc accessibles depuis la première face 112 et depuis cette autre face 122 du deuxième substrat 108. Un matériau getter 124 est disposé dans la cavité 120.3 au niveau de laquelle aucune portion 118 n'a été réalisée car une pression résiduelle très faible sera recherchée dans cette cavité 120.3.

Dans l'exemple décrit ici, les cavités 120.1, 120.2 et 120.3 ont des dimensions identiques, mais il est possible de réaliser des cavités de dimensions différentes les unes par rapport aux autres.

Comme représenté sur la figure 3, le substrat capot 106 obtenu est solidarisé au premier substrat 104 par exemple par scellement métallique, anodique ou par verre fritté, via un joint de scellement 126 formé entre le substrat capot 106 et le premier substrat 104. Ce scellement s'effectue sous vide poussé, par exemple à une pression comprise entre environ $10^{-3}$ mbar et $10^{-5}$ mbar, ou même inférieure à $10^{-5}$ mbar, afin de chasser l'air présent entre le substrat capot 106 et le premier substrat 104 et réduire ainsi la quantité de gaz résiduels réactifs dans les cavités. Lorsque le premier substrat 104 et le deuxième substrat 108 comportent un même matériau, par exemple un semi-conducteur, cette solidarisation peut être obtenue par la mise en oeuvre d'un scellement moléculaire basse température (par exemple mis en oeuvre à une température inférieure ou égale à environ 400°C) entre le premier substrat 104 et le deuxième substrat 108. Dans ce cas, aucun joint de scellement n'est présent entre les deux substrats 104 et 108.

L'assemblage obtenu est ensuite placé dans une chambre dans laquelle se trouve le gaz noble sous pression et destiné à être injecté dans les cavités 120.1 et 120.2. Ce gaz noble est ici de l'argon et/ou de l'hélium, et la pression utilisée est comprise entre environ 1 bar et 6 bars. Compte tenu des plus grandes dimensions (dans le plan (X,Y)) de la portion 118.1 par rapport à celles de la portion 118.2, la quantité de gaz noble qui est injecté dans la première cavité 120.1 à travers la portion 118.1 est donc plus importante que celle du gaz noble injecté dans la deuxième cavité 120.2 à travers la portion 118.2. Aucun gaz noble n'est injecté dans la troisième cavité 120.3 du fait qu'aucune portion de matériau perméable au gaz noble n'a été réalisée pour former une partie d'une paroi de cette troisième cavité 120.3.

De manière générale, la quantité de gaz noble injecté dans une cavité 120 est fonction de la taille de l'ouverture formée par la portion 118 qui forme au moins une partie d'une paroi de cette cavité 120, c'est-à-dire des dimensions de cette portion 118 dans un plan parallèle à un plan principal du substrat dans lequel la portion 118 est réalisée, et également de l'épaisseur du matériau de la portion 118 (l'épaisseur correspondant à la dimension qui est perpendiculaire aux dimensions de la portion 118 se trouvant dans ledit plan parallèle au plan principal du substrat), au volume de la cavité 120, à la pression de gaz noble à laquelle la portion 118 est exposée, et à la durée pendant laquelle la portion 118 est exposée au gaz noble sous pression. Ainsi, en fonction de la pression (P) d'hélium, de la température (T) dans la chambre dans laquelle l'injection est réalisée, de la surface (S) de la portion 118 à travers laquelle le gaz noble est injecté, à l'épaisseur (e) de la portion 118, de la durée (t) de l'étape d'injection et du volume (V) de la cavité 120, on obtient dans la cavité 120 une pression résiduelle ΔP égale à:

$$\Delta P = K.S.t.P/(e.V)$$

où K est un coefficient qui dépend de la température T et de la nature du matériau formant la portion 118. A titre d'exemple, pour une portion 118 composée de verre utilisé en scellement anodique (verre de dénominations commerciales « Pyrex » ou « Borofloat ») et pour les paramètres suivants : P = 1 bar, T = 20°C, t = 1200 s, S = 10 mm$^2$, e = 0,5 mm, V = 0,3 mm$^3$, et de l'hélium injecté, on obtient ΔP = 10$^{-1}$ mbar.

Avec T = 100°C (les valeurs des autres paramètres étant similaires aux valeurs précédentes), une pression ΔP égale à 10$^{-1}$ mbar peut être atteinte avec une durée t égale à seulement 5 secondes.

Les différentes cavités 120 sont ensuite fermées hermétiquement via la formation, sur la face supérieure du substrat capot 106, d'une couche 128 de matériau non perméable à l'atmosphère ambiante et au gaz noble, correspondant par exemple à une couche métallique pouvant comporter du titane et/ou de l'aluminium et/ou du cuivre et/ou du zirconium, ou une couche de semi-conducteur, dont l'épaisseur est comprise entre environ 0,5 et 10 μm, ou entre 0,5 μm et 2 μm (figure 4). La couche 128 peut être déposée via un dépôt PVD.

Le procédé d'encapsulation peut être achevé en réalisant une activation thermique du matériau getter 124. Le matériau getter 124 pompe alors les éventuels gaz résiduels non neutres présents dans la cavité 120.3, comme par exemple l'oxygène, l'azote, l'hydrogène, l'eau, le monoxyde de carbone ou le dioxyde de carbone. Par contre, les gaz neutres tels que le gaz noble ne sont pas pompés par le matériau getter car, du fait que les gaz nobles sont non réactifs, ils ne réagissent pas avec le matériau getter 124.

Cette activation thermique du matériau getter 124 aurait également pu être réalisée au cours de l'assemblage du substrat capot 106 avec le premier substrat 104.

Le composant 100 comprenant les trois dispositifs microélectroniques 102.1, 102.2 et 102.3 encapsulés se retrouve alors achevé.

Dans l'exemple décrit ici, le gyroscope 102.3 est encapsulé dans la troisième cavité 120.3 avec une pression résiduelle très faible, par exemple inférieure à environ 10$^{-1}$ mbar, et par exemple comprise entre 10$^{-3}$ mbar et 10$^{-4}$ mbar, du fait que le scellement entre le substrat capot 106 et le premier substrat 104 a été réalisé sous vide poussé, et également grâce au fait qu'aucun gaz noble n'est injecté dans la cavité 120.3 et que le matériau getter 124 réalise en outre un absorption / adsorption des gaz non neutres une fois celui-ci activé thermiquement. L'accéléromètre 102.2 est encapsulé dans la deuxième cavité 120.2 avec une pression résiduelle de gaz noble par exemple comprise entre environ 10 mbar et 100 mbar. Enfin, l'accéléromètre 102.1 est encapsulé dans la première cavité 120.1 avec une pression résiduelle de gaz noble supérieure à celle dans la deuxième cavité 120.2 compte tenu des dimensions plus importantes de la portion 118.1 par rapport à la portion 118.2 qui ont permis d'injecter une plus grande quantité de gaz dans cette cavité 120.1, et par exemple comprise entre environ 100 mbar et 1 bar.

Dans l'exemple précédemment décrit, seuls trois dispositifs microélectroniques 102 réalisés sur le premier substrat 104 sont encapsulés. Toutefois, un nombre différent, et notamment plus important, de dispositifs microélectroniques peut être réalisé sur le premier substrat. Les différents dispositifs encapsulés collectivement, formant différents composants ou puces, peuvent être ensuite séparés les uns des autres via la découpe de l'assemblage réalisé. Un composant peut comporter une ou plusieurs cavités dans lesquelles un ou plusieurs dispositifs microélectroniques sont encapsulés.

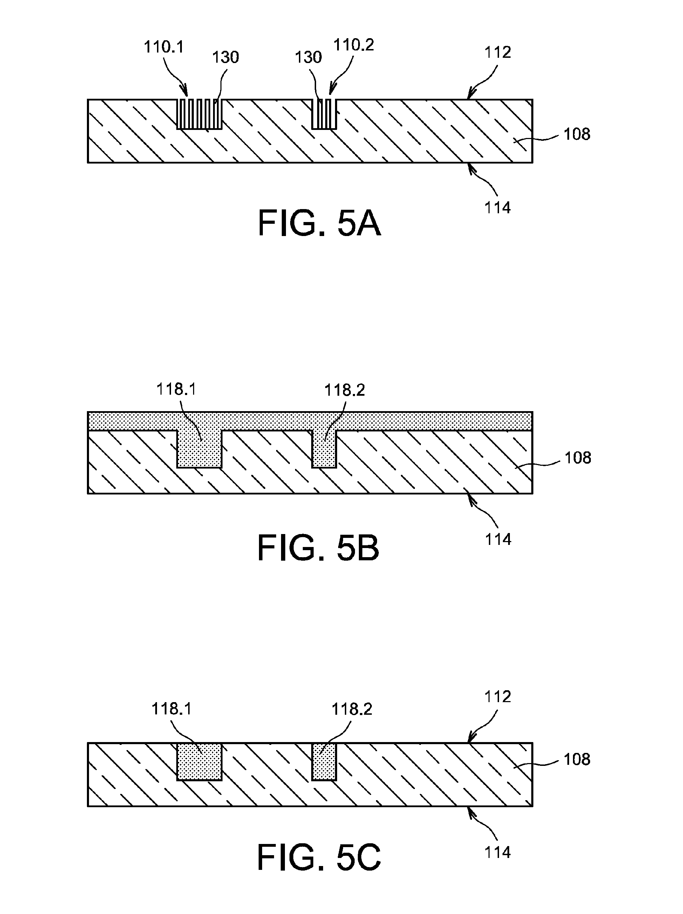

Une première variante de réalisation du substrat capot 106 est maintenant décrite en liaison avec les figures 5A à 5D.

Comme précédemment, le deuxième substrat 108 est utilisé.

Les ouvertures 110 sont ensuite réalisées à travers une partie de l'épaisseur du deuxième substrat 108. Toutefois, contrairement au précédent exemple de réalisation dans lequel les ouvertures 110 sont réalisées par une simple gravure, les ouvertures 110 (110.1 et 110.2 sur la figure 5A) sont ici réalisées telles que des portions restantes 130 du matériau du deuxième substrat 108 soient présentes dans les ouvertures 110. Dans l'exemple décrit ici, la gravure mise en oeuvre est de type DRIE (gravure ionique réactive profonde) et forme des piliers 130 de semi-conducteur dans ces ouvertures 110. Ces portions restantes 130 de matériau sont réalisées telles qu'elles puissent être transformées ultérieurement pour former les portions 118 du premier matériau.

Comme représenté sur la figure 5B, une étape d'oxydation, par exemple une oxydation thermique, est ensuite mise en oeuvre, par exemple à une température comprise entre environ 1000°C et 1200°C. Cette étape d'oxydation permet de transformer les portions restantes 130 présentes dans les ouvertures 110, formant ainsi dans ces ouvertures 110 les portions 118 du premier matériau (118.1 et 118.2 sur la figure 5B) comprenant un oxyde de semi-conducteur (SiO$_2$ dans le cas présent) qui est non perméable à l'atmosphère ambiante, mais perméable au gaz noble destiné à être injecté dans les cavités. Cette étape d'oxydation forme également de l'oxyde de semi-conducteur sur la première face 112 du deuxième substrat 108. L'épaisseur d'oxyde formé peut être comprise entre environ 1 μm et 10 μm.

L'oxyde de semi-conducteur se trouvant en dehors des ouvertures 110 est ensuite supprimé, par exemple via une planarisation mécano-chimique mise en oeuvre avec arrêt sur la première face 112 du deuxième substrat 108 (voir figure 5C).

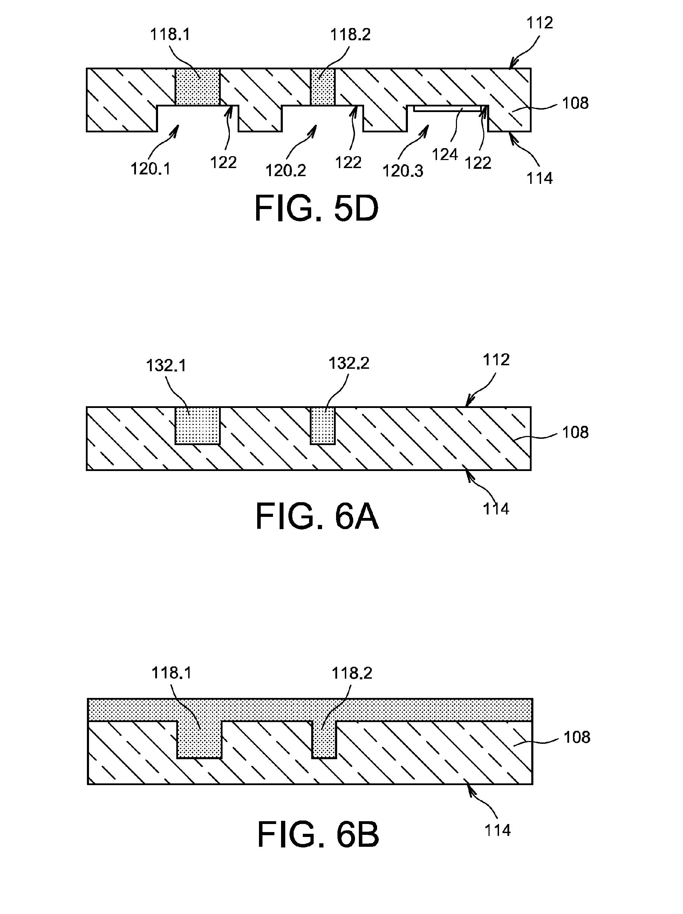

Le substrat capot 106 est ensuite achevé de manière analogue au précédent exemple de réalisation du substrat capot 106, c'est-à-dire en gravant à travers la deuxième face 114 du deuxième substrat 108 les cavités 120 jusqu'à atteindre l'autre face 122 du deuxième substrat 108 (voir figure 5D), et en déposant éventuellement un matériau getter dans la ou les cavités dans lesquelles un absorption gazeuse est souhaitée.

Une deuxième variante de réalisation du substrat capot 106 est décrite en liaison avec les figures 6A et 6B.

Comme précédemment, le deuxième substrat 108 est utilisé. On réalise ensuite, au niveau des emplacements des portions du premier matériau 118, des portions de semi-conducteur poreux 132 (référencées 132.1 et 132.2 sur la figure 6A). L'épaisseur de ces portions de semi-conducteur poreux 132 est par exemple comprise entre environ 10 $\mu$m et 200 $\mu$m. Ces portions de semi-conducteur poreux 132 sont par exemple réalisées par gravure HF sous courant telle qu'une anodisation.

Comme précédemment décrit en liaison avec la figure 5B, une étape d'oxydation telle qu'une oxydation thermique est ensuite mise en oeuvre afin de transformer les portions poreuses 132 en portions 118 d'oxyde (figure 6B). Le substrat capot 106 est ensuite achevé par la mise en oeuvre des étapes précédemment décrites en liaison avec les figures 5C et 5D.

Dans les exemples précédemment décrits, les cavités 120 sont réalisées par gravure du deuxième substrat 108. En variante, il est possible que les cavités 120 soient formées dans le premier substrat 104, les dispositifs microélectroniques 102 étant disposés au-dessus de ces cavités. Dans ce cas, l'étape de réalisation des cavités 120 dans le deuxième substrat 108 est remplacée par une étape d'amincissement (par exemple via un meulage ou une planarisation mécano-chimique) de l'ensemble du deuxième substrat 108 mise en oeuvre depuis la deuxième face 114, jusqu'à atteindre l'autre face 122 et découvrir ainsi, ou révéler, les portions 118 réalisées dans le deuxième substrat 108.

Selon une autre variante, il est possible que les parois latérales des cavités 120 soient formées par des portions de matériau distinctes du premier substrat 104 et du deuxième substrat 108. Dans ce cas, l'étape d'amincissement du deuxième substrat 108 depuis la deuxième face 114 est également réalisée.

Selon une variante de réalisation, le premier matériau des portions 118 pourrait être du nitrure de semi-conducteur, par exemple du SiN ou du $Si_3N_4$.

Selon une autre variante, le ou les matériaux getter disposés dans une ou plusieurs cavités peuvent être disposés au niveau de n'importe quelle paroi de cette ou ces cavités, mais pas sur les parois formées par les portions 118.

**Revendications**

1. Procédé d'encapsulation d'au moins un dispositif microélectronique (102.1, 102.2), comportant au moins les étapes de :

    - réalisation du dispositif microélectronique (102.1, 102.2) sur un premier substrat (104) ;
    - réalisation d'au moins une portion (118.1, 118.2) d'un premier matériau non perméable à l'atmosphère ambiante et perméable à au moins un gaz noble dans un deuxième substrat (108) non perméable à l'atmosphère ambiante et au gaz noble, ladite portion (118.1, 118.2) du premier matériau s'étendant depuis une première face (112) du deuxième substrat (108) jusqu'à une autre face (122) du deuxième substrat (108) opposée à la première face (112) ;
    - solidarisation du deuxième substrat (108) au premier substrat (104), formant au moins une cavité (120.1, 120.2) dans laquelle est encapsulé le dispositif microélectronique (102.1, 102.3) telle que ladite portion (118.1, 118.2) du premier matériau forme au moins une partie d'une paroi de la cavité (120.1, 120.2) ;
    - injection du gaz noble dans la cavité (120.1, 120.2) à travers la portion (118.1, 118.2) du premier matériau ;
    - fermeture hermétique de la cavité (120.1, 120.2) vis-à-vis de l'atmosphère ambiante et du gaz noble ;
    le ou les gaz de l'atmosphère ambiante étant différents du gaz noble.

2. Procédé selon la revendication 1, dans lequel la réalisation de la portion (118.1, 118.2) du premier matériau comporte la mise en oeuvre des étapes suivantes :

    - réalisation, à travers la première face (112) du deuxième substrat (108), d'au moins une ouverture (110.1, 110.2) dans une partie de l'épaisseur du deuxième substrat (108) ;
    - formation de la portion (118.1, 118.2) du premier matériau dans l'ouverture (110.1, 110.2) ;
    - suppression d'une partie du deuxième substrat (108) depuis une deuxième face (114) du deuxième substrat (108) opposée à la première face (112), découvrant la portion (118.1, 118.2) du premier matériau et formant ladite autre face (122) du deuxième substrat (108).

3. Procédé selon la revendication 2, dans lequel le premier matériau comporte du verre ou de l'oxyde de semi-conducteur.

4. Procédé selon la revendication 3, dans lequel le premier matériau comporte du verre et la formation de la portion (118.1, 118.2) du premier matériau dans l'ouverture (110.1, 110.2) comporte la mise en oeuvre des étapes suivantes :

- solidarisation d'un troisième substrat (116) de verre contre la première face (112) du deuxième substrat (108) et en regard de l'ouverture (110.1, 110.2) ;
- refusion du verre d'au moins une partie du troisième substrat (116) dans l'ouverture (110.1, 110.2), formant la portion (118.1, 118.2) du premier matériau dans l'ouverture (110.1, 110.2).

5. Procédé selon la revendication 4, comportant en outre, après l'étape de refusion du verre, une étape de suppression du verre du troisième substrat (116) se trouvant en dehors de l'ouverture (110.1, 110.2).

6. Procédé selon la revendication 3, dans lequel le deuxième substrat (108) comporte du semi-conducteur, et dans lequel l'étape de réalisation de l'ouverture (110.1, 110.2) comporte la mise en oeuvre d'une gravure dans ladite partie de l'épaisseur du deuxième substrat (108) telle que des portions restantes (130) du semi-conducteur du deuxième substrat (108) soient conservées dans l'ouverture (110.1, 110.2), la formation de la portion (118.1, 118.2) du premier matériau dans l'ouverture (110.1, 110.2) comportant la mise en oeuvre d'une oxydation desdites portions restantes (130) de semi-conducteur.

7. Procédé selon la revendication 1, dans lequel le deuxième substrat (108) comporte du semi-conducteur, et dans lequel la réalisation de la portion (118.1, 118.2) du premier matériau comporte la mise en oeuvre des étapes suivantes :

- réalisation, à travers la première face (112) du deuxième substrat (108), de porosités dans une partie de l'épaisseur du deuxième substrat (108) ;
- oxydation de la partie poreuse (132.1, 132.2) du deuxième substrat (108), formant la portion (118.1, 118.2) du premier matériau ;
- suppression d'une partie du deuxième substrat (108) depuis une deuxième face (114) du deuxième substrat (108) opposée à la première face (112), découvrant la portion (118.1, 118.2) du premier matériau et formant ladite autre face (122) du deuxième substrat (108).

8. Procédé selon l'une des revendications 6 ou 7, comportant en outre, après l'étape d'oxydation et lorsque l'oxydation mise en oeuvre forme de l'oxyde de semi-conducteur en dehors de l'ouverture (110.1, 110.2), une suppression de l'oxyde de semi-conducteur se trouvant en dehors de l'ouverture (110.1, 110.2).

9. Procédé selon l'une des revendications précédentes, dans lequel la fermeture hermétique de la cavité (120.1, 120.2) vis-à-vis de l'atmosphère ambiante et du gaz noble comporte la mise en oeuvre d'un dépôt d'au moins un deuxième matériau (128) non perméable au gaz noble au moins contre ladite portion (118.1, 118.2) du premier matériau, au niveau de la première face (112) du deuxième substrat (108).

10. Procédé selon l'une des revendications précédentes, dans lequel les étapes mises en oeuvre réalisent une encapsulation d'au moins deux dispositifs microélectroniques (102.1, 102.2, 102.3) dans au moins deux cavités (120.1, 120.2, 120.3) distinctes formées entre le premier substrat (104) et le deuxième substrat (108), et telles qu'au moins une portion (118.1, 118.2) du premier matériau forme au moins une partie d'une paroi d'une des cavités (120.1, 120.2).

11. Procédé selon la revendication 10, dans lequel les étapes mises en oeuvre réalisent au moins deux portions (118.1, 118.2) du premier matériau formant chacune au moins une partie d'une paroi d'une des deux cavités (120.1, 120.2).

12. Procédé selon la revendication 11, dans lequel lesdites au moins deux portions (118.1, 118.2) du premier matériau comportent des dimensions, au niveau de la première face (112) du deuxième substrat (108) et/ou de l'autre face (122) du deuxième substrat (108), différentes l'une par rapport à l'autre.

13. Procédé selon l'une des revendications 10 à 12, dans lequel au moins un des dispositifs microélectroniques (102.3) est encapsulé dans une des cavités (120.3) telle qu'aucune paroi de ladite une des cavités (120.3) n'est perméable au gaz noble.

14. Procédé selon l'une des revendications précédentes, comportant en outre, préalablement à l'étape de solidarisation du deuxième substrat (108) au premier substrat (104), la réalisation d'au moins une portion de matériau getter (124) dans une ou plusieurs des cavités (120.3).

15. Procédé selon la revendication 13, dans lequel le dispositif microélectronique (102.3) encapsulé dans la cavité (120.3) dont aucune paroi n'est perméable au gaz noble est un gyroscope, et au moins l'autre des dispositifs microélectroniques (102.1) est un accéléromètre.

16. Procédé selon l'une des revendications précédentes, dans lequel le gaz noble comporte de l'hélium et/ou de l'argon et/ou du néon, et/ou dans lequel l'étape d'injection du gaz noble dans la cavité (120.1, 120.2) à travers la portion (118.1, 118.2) du premier matériau est réalisée en exposant au moins la première face (112) du deuxième substrat (108) au gaz noble à une pression comprise entre environ 1 bar et 6 bars.

**Patentansprüche**

1. Verfahren zum Einkapseln wenigstens einer mikroelektronischen Vorrichtung (102.1, 102.2), umfassend wenigstens die folgenden Schritte:

   - Herstellen der mikroelektronischen Vorrichtung (102.1, 102.2) auf einem ersten Substrat (104);
   - Herstellen wenigstens eines Bereichs (118.1, 118.2) eines ersten Materials, das für die Umgebungsatmosphäre undurchlässig und für wenigstens ein Edelgas durchlässig ist, in einem zweiten Substrat (108), das für die Umgebungsatmosphäre und für das Edelgas undurchlässig ist, wobei der Bereich (118.1, 118.2) des ersten Materials sich von einer ersten Fläche (112) des zweiten Substrats (108) bis zu einer anderen Fläche (122) des zweiten Substrats (108) erstreckt, die der ersten Fläche (112) entgegengesetzt ist;
   - Verbinden des zweiten Substrats (108) mit dem ersten Substrat (104), wodurch wenigstens ein Hohlraum (120.1, 120.2) gebildet wird, in dem die mikroelektronische Vorrichtung (102.1, 102.3) derart eingekapselt ist, dass der Bereich (118.1, 118.2) des ersten Materials wenigstens einen Teil einer Wand des Hohlraums (120.1, 120.2) bildet;
   - Injizieren des Edelgases in den Hohlraum (120.1, 120.2) durch den Bereich (118.1, 118.2) des ersten Materials hindurch;
   - hermetisches Schließen des Hohlraums (120.1, 120.2) gegenüber der Umgebungsatmosphäre und dem Edelgas;
   wobei das Gas oder die Gase der Umgebungsatmosphäre von dem Edelgas verschieden sind.

2. Verfahren nach Anspruch 1, bei dem das Herstellen des Bereichs (118.1, 118.2) des ersten Materials die Durchführung der folgenden Schritte beinhaltet:

   - Herstellen wenigstens einer Öffnung (110.1, 110.2) in einem Teil der Dicke des zweiten Substrats (108) durch die erste Fläche (112) des zweiten Substrats (108) hindurch;
   - Bilden des Bereichs (118.1, 118.2) des ersten Materials in der Öffnung (110.1, 110.2);
   - Entfernen eines Teils des zweiten Substrats (108) von einer zweiten Fläche (114) des zweiten Substrats (108) aus, die der ersten Fläche (112) entgegengesetzt ist, wodurch der Bereich (118.1, 118.2) des ersten Materials freigelegt wird und die andere Fläche (122) des zweiten Substrats (108) bildet.

3. Verfahren nach Anspruch 2, bei dem das erste Material Glas oder Halbleiteroxid umfasst.

4. Verfahren nach Anspruch 3, bei dem das erste Material Glas umfasst und das Bilden des Bereichs (118.1, 118.2) des ersten Materials in der Öffnung (110.1, 110.2) die Durchführung der folgenden Schritte umfasst:

   - Anbringen eines dritten Substrats (116) aus Glas an der ersten Fläche (112) des zweiten Substrats (108) und gegenüber der Öffnung (110.1, 110.2);
   - Schmelzen des Glases wenigstens eines Teils des dritten Substrats (116) in der Öffnung (110.1, 110.2) zum Bilden des Bereichs (118.1, 118.2) des ersten Materials in der Öffnung (110.1, 110.2).

5. Verfahren nach Anspruch 4, ferner umfassend, nach dem Schritt des Schmelzens des Glases, einen Schritt des Entfernens des Glases des dritten Substrats (116), das sich außerhalb der Öffnung (110.1, 110.2) befindet.

6. Verfahren nach Anspruch 3, bei dem das zweite Substrat (108) Halbleiter umfasst, und bei dem der Schritt des Herstellens der Öffnung (110.1, 110.2) die Durchführung einer Gravur in dem Teil der Dicke des zweiten Substrats (108) derart umfasst, dass die verbleibenden Bereiche (130) des Halbleiters des zweiten Substrats (108) in der Öffnung (110.1, 110.2) bewahrt werden, wobei das Bilden des Bereichs (118.1, 118.2) des ersten Materials in der Öffnung (110.1, 110.2) die Durchführung einer Oxidation der verbleibenden Bereiche (130) von Halbleiter umfasst.

7. Verfahren nach Anspruch 1, bei dem das zweite Substrat (108) Halbleiter umfasst, und bei dem das Herstellen des Bereichs (118.1, 118.2) des ersten Materials die Durchführung der folgenden Schritte umfasst:

   - Herstellen von Porositäten in einem Teil der Dicke des zweiten Substrats (108) durch die erste Fläche (112) des zweiten Substrats (108) hindurch;
   - Oxidation des porösen Teils (132.1, 132.2) des zweiten Substrats (108) zum Bilden des Bereichs (118.1, 118.2) des ersten Materials;
   - Entfernen eines Teils des zweiten Substrats (108) von einer zweiten Fläche (114) des zweiten Substrats (108) aus, die der ersten Fläche (112) entgegengesetzt ist, wodurch der Bereich (118.1, 118.2) des ersten Materials freigelegt wird und die andere Fläche (122) des zweiten Substrats (108) bildet.

**8.** Verfahren nach einem der Ansprüche 6 oder 7, ferner umfassend, nach dem Schritt der Oxidation und wenn die durchgeführte Oxidation Halbleiteroxid außerhalb der Öffnung (110.1, 110.2) bildet, ein Entfernen des Halbleiteroxids, das sich außerhalb der Öffnung (110.1, 110.2) befindet.

**9.** Verfahren nach einem vorhergehenden Ansprüche, bei dem das hermetische Schließen des Hohlraums (120.1, 120.2) gegenüber der Umgebungsatmosphäre und dem Edelgas die Durchführung einer Aufbringung wenigstens eines zweiten Materials (128), das für das Edelgas undurchlässig ist, wenigstens an dem Bereich (118.1, 118.2) des ersten Materials im Bereich der ersten Fläche (112) des zweiten Substrats (108) umfasst.

**10.** Verfahren nach einem der vorhergehenden Ansprüche, bei dem die durchgeführten Schritte eine Einkapselung von wenigstens zwei mikroelektronischen Vorrichtungen (102.1, 102.2, 102.3) in wenigstens zwei getrennten Hohlräumen (120.1, 120.2, 120.3) bewirken, die zwischen dem ersten Substrat (104) und dem zweiten Substrat (108) gebildet sind, derart, dass wenigstens ein Bereich (118.1, 118.2) des ersten Materials wenigstens einen Teil einer Wand eines der Hohlräume (120.1, 120.2) bildet.

**11.** Verfahren nach Anspruch 10, bei dem die durchgeführten Schritte wenigstens zwei Bereiche (118.1, 118.2) des ersten Materials bewirken, die jeweils wenigstens einen Teil einer Wand eines der zwei Hohlräume (120.1, 120.2) bilden.

**12.** Verfahren nach Anspruch 11, bei dem die wenigstens zwei Bereiche (118.1, 118.2) des ersten Materials voneinander unterschiedliche Abmessungen im Bereich der ersten Fläche (112) des zweiten Substrats (108) und/oder der anderen Fläche (122) des zweiten Substrats (108) umfassen.

**13.** Verfahren nach einem der Ansprüche 10 bis 12, bei dem wenigstens eine der mikroelektronischen Vorrichtungen (102.3) derart in einem der Hohlräume (120.3) eingekapselt ist, dass keine Wand des einen Hohlraums (120.3) für das Edelgas durchlässig ist.

**14.** Verfahren nach einem der vorhergehenden Ansprüche, ferner umfassend, vor dem Schritt des Verbindens des zweiten Substrats (108) mit dem ersten Substrat (104), die Herstellung wenigstens eines Bereichs von Gettermaterial (124) in einem oder mehreren der Hohlräume (120.3).

**15.** Verfahren nach Anspruch 13, bei dem die mikroelektronische Vorrichtung (102.3), die in dem Hohlraum (120.3) eingekapselt ist, bei dem keine Wand für das Edelgas durchlässig ist, ein Gyroskop ist, und wenigstens die andere der mikroelektronischen Vorrichtungen (102.1) ein Beschleunigungsmesser ist.

**16.** Verfahren nach einem der vorhergehenden Ansprüche, bei dem das Edelgas Helium und/oder Argon und/oder Neon umfasst, und/oder bei dem der Schritt des Injizierens des Edelgases in den Hohlraum (120.1, 120.2) durch den Bereich (118.1, 118.2) des ersten Materials hindurch durchgeführt wird, indem man wenigstens die erste Fläche (112) des zweiten Substrats (108) dem Edelgas bei einem Druck aussetzt, der zwischen ungefähr 1 bar und 6 bar enthalten ist.

**Claims**

**1.** Process for encapsulating at least one microelectronic device (102.1, 102.2), comprising at least the following steps:

- make the microelectronic device (102.1, 102.2) on a first substrate (104);
- make at least one portion (118.1, 118.2) of a first material not permeable to the ambient atmosphere and permeable to at least one noble gas in a second substrate (108) not permeable to the ambient atmosphere and to the noble gas, said portion (118.1, 118.2) of the first material extending from a first face (112) of the second substrate (108) as far as another face (122) of the second substrate (108) opposite the first face (112);
- secure the second substrate (108) to the first substrate (104), forming at least one cavity (120.1, 120.2) inside which the microelectronic device (102.1, 102.3) is encapsulated such that said portion (118.1, 118.2) of the first material forms at least part of a wall of the cavity (120.1, 120.2);
- inject the noble gas into the cavity (120.1, 120.2) through the portion (118.1, 118.2) of the first material;
- hermetically seal the cavity (120.1, 120.2) towards the ambient atmosphere and the noble gas;

the gas or gases of the ambient atmosphere being different from the noble gas.

**2.** Process according to claim 1, in which production of the portion (118.1, 118.2) of the first material includes the following steps:

- produce at least one opening (110.1, 110.2) in a part of the thickness of the second substrate (108) through the first face (112) of the second substrate (108);
- make the portion (118.1, 118.2) of the first material in the opening (110.1, 110.2);
- eliminate part of the second substrate (108) from a second face (114) of the second substrate (108) opposite the first face (112), exposing the portion (118.1, 118.2) of the first material and forming said other face (122) of the second substrate (108).

3. Process according to claim 2, in which the first material includes glass or semiconducting oxide.

4. Process according to claim 3, in which the first material includes glass and the making of the portion (118.1, 118.2) of the first material in the opening (110.1, 110.2) includes the following steps:

- secure a third glass substrate (116) in contact with the first face (112) of the second substrate (108) and facing the opening (110.1, 110.2);
- remelt the glass of at least part of the third substrate (116) in the opening (110.1, 110.2), forming the portion (118.1, 118.2) of the first material in the opening (110.1, 110.2).

5. Process according to claim 4, also comprising a step to eliminate the glass of the third substrate (116) located outside the opening (110.1, 110.2), after the glass remelting step.

6. Process according to claim 3, in which the second substrate (108) comprises a semiconductor, and in which production of the opening (110.1, 110.2) includes etching in said part of the thickness of the second substrate (108) such that the remaining portions (130) of the semiconductor of the second substrate (108) remain in the opening (110.1, 110.2), the making of the portion (118.1, 118.2) of the first material in the opening (110.1, 110.2) including oxidation of said remaining portions (130) of the semiconductor.

7. Process according to claim 1, in which the second substrate (108) includes a semiconductor, and the making of the portion (118.1, 118.2) of the first material includes the following steps:

- produce porosities in part of the thickness of the second substrate (108) through the first face (112) of the second substrate (108);
- oxidise the porous part (132.1, 132.2) of the second substrate (108), forming the portion (118.1, 118.2) of the first material;
- eliminate part of the second substrate (108) from a second face (114) of the second substrate (108) opposite the first face face (112), exposing the portion (118.1, 118.2) of the first material and forming said other face (122) of the second substrate (108).

8. Process according to one of claims 6 or 7, also including a step to eliminate the semiconductor oxide located outside the opening (110.1, 110.2) after the oxidation step and when the oxidation applied forms the semiconductor oxide outside the opening (110.1, 110.2).

9. Process according to one of previous claims, in which hermetic sealing of the cavity (120.1, 120.2) towards the ambient atmosphere and the noble gas include the deposition of at least one second material (128) not permeable to the noble gas at least in contact with said portion (118.1, 118.2) of the first material, at the first face (112) of the second substrate (108).

10. Process according to one of previous claims, in which the steps which are carried out include encapsulation of at least two microelectronic devices (102.1, 102.2, 102.3) in at least two distinct cavities (120.1, 120.2, 120.3) formed between the first substrate (104) and the second substrate (108), such that at least one portion (118.1, 118.2) of the first material forms at least part of a wall of one of the cavities (120.1, 120.2).

11. Process according to claim 10, in which the steps which are carried out make at least two portions (118.1, 118.2) of the first material each forming at least part of a wall of one of the two cavities (120.1, 120.2).

12. Process according to claim 11, in which said at least two portions (118.1, 118.2) of the first material have dimensions, at the first face (112) of the second substrate (108) and/or the other face (122) of the second substrate (108), which are different one to each other.

13. Process according to one of claims 10 to 12, in which at least one of the microelectronic devices (102.3) is encapsulated in one of the cavities (120.3) such that no wall of said one of the cavities (120.3) is permeable to the noble gas.

14. Process according to one of previous claims, also including production of at least one portion of getter material (124) in one or several cavities (120.3), before the step in which the second substrate (108) is secured to the first substrate (104).

15. Process according to claim 13, in which the microelectronic device (102.3) encapsulated in the cavity (120.3) of which no wall is permeable to the noble gas is a gyroscope, and at least the other of the microelectronic devices (102.1) is an accelerometer.

16. Process according to one of previous claims, in which the noble gas includes helium and/or argon and/or neon, and/or the step to inject a noble gas into the cavity (120.1, 120.2) through the portion (118.1, 118.2) of the first material is carried out by exposing at least the first face (112) of the second substrate (108) to the noble gas at a pressure of between about 1 bar and 6 bars.

FIG. 1

FIG. 2A

FIG. 2B

110.1    110.2                116

112

108

114

FIG. 2C

118.1    118.2                116

112

108

114

FIG. 2D

118.1    118.2    112

108

114

FIG. 2E

118.1      118.2      112    106

108

120.1    122    120.2    122    120.3   124   122    114

# FIG. 2F

120.1   118.1   120.2   118.2   120.3   124   112   106

z

108

x

126

y

122    122    122    104

102.1     102.2     102.3

# FIG. 3

128   120.1   118.1   120.2   118.2   120.3   124   112   100

108

126

122    122    122    104

102.1     102.2     102.3

# FIG. 4

**FIG. 5A**

**FIG. 5B**

**FIG. 5C**

FIG. 5D

FIG. 6A

FIG. 6B

**EP 2 803 634 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 8350346 B1
- FR 2841380 A1